# EUROPEAN PATENT APPLICATION

(11) **EP 4 462 139 A1**
(43) Date of publication of application: **13.11.2024**
(21) Application number: 23753113.2
(22) Date of filing: 07.02.2023
(51) Int. Cl.: G01R 31/367, G01R 31/392, G01R 31/371, G01R 31/396, G01R 31/36, G07C 5/02, H01M 10/48, H01M 10/42, G06N 20/00

(54) **BATTERY MANAGEMENT APPARATUS AND OPERATION METHOD THEREFOR**

(30) Priority: 08.02.2022 KR 20220016540
(71) Applicant: LG Energy Solution, Ltd., Seoul 07335 (KR)
(72) Inventor: SONG, Yee Gahng, Daejeon 34122 (KR)
(74) Representative: Plasseraud IP
(86) International application number: PCT/KR2023/001726
(87) International publication number: WO 2023/153765

(57) **Abstract**

A battery management apparatus according to an embodiment disclosed herein includes a data management unit configured to generate time period-specific life change information of a battery based on life (state of health (SoH)) change information of the battery and a controller configured to predict a time period-specific end of life (EoL) of the battery based on the time period-specific life change information of the battery.

## Description

### [TECHNICAL FIELD]

### CROSS-REFERENCE TO RELATED APPLICATION

This application claims priority to and the benefit of Korean Patent Application No. 10-2022-0016540 filed in the Korean Intellectual Property Office on February 8, 2022, the entire contents of which are incorporated herein by reference.

### TECHNICAL FIELD

Embodiments disclosed herein relate to a battery management apparatus and an operating method thereof.

### [BACKGROUND ART]

An electric vehicle is supplied with electricity from outside to charge a battery, and then a motor is driven by a voltage charged in the battery to obtain power. The battery of the electric vehicle may have heat generated therein by chemical reaction occurring in a process of charging and discharging electricity, and the heat may impair performance and lifetime of the battery. Thus, a battery management apparatus (or a battery management system (BMS)) that monitors and controls temperature, voltage, and current of the battery is driven to diagnose the state of the battery.

However, a conventional battery management apparatus calculates a life deterioration rate or a SoH deterioration rate of a battery, which corresponds to a total use time of the battery, and thus is incapable of identifying a change in the deterioration rate or SoH of the battery due to a user's driving pattern changing in real time or an event occurring in a vehicle.

### [DISCLOSURE]

### [TECHNICAL PROBLEM]

Embodiments disclosed herein aim to provide a battery management apparatus and an operating method thereof in which a SoH deterioration rate of a battery is analyzed for each time period to provide expected end-of-life information of a battery for multiple time periods reflecting the latest driving history of a vehicle.

Technical problems of the embodiments disclosed herein are not limited to the above-described technical problems, and other unmentioned technical problems would be clearly understood by one of ordinary skill in the art from the following description.

### [TECHNICAL SOLUTION]

A battery management apparatus according to an embodiment disclosed herein includes a data management unit configured to generate time period-specific life change information of a battery based on life (state of health (SoH)) change information of the battery and a controller configured to predict a time period-specific end of life (EoL) of the battery by processing the time period-specific life change information of the battery.

According to an embodiment, the battery management apparatus may further include a communication unit configured to transmit the time period-specific life change information of the battery and the time period-specific end of life of the battery to another device of a vehicle having the battery mounted thereon.

According to an embodiment, the data management unit may be further configured to generate life change information of the battery over time based on at least any one of voltage, current, temperature of the battery or state information of a battery pack having the battery mounted thereon.

According to an embodiment, the data management unit may be further configured to generate at least any one of a short-term life change pattern, a mid-term life change pattern, and a long-term life change pattern of the battery based on the life change information of the battery over time.

According to an embodiment, the data management unit may be further configured to generate the time period-specific life change information of the battery by calculating a simple average value of the life change information of the battery for each time period or inputting the life change information of the battery into any one of a moving average filter (MAF) or a recursive weighted filter.

According to an embodiment, the controller may be further configured to obtain driving information of a vehicle having the battery mounted thereon and predict the time period-specific end of life of the battery based on a latest driving history of the vehicle and the time period-specific life change information of the battery.

According to an embodiment, the controller may be further configured to predict the time period-specific end of life of the battery, which corresponds to at least any one of a short-term change pattern, a mid-term change pattern, and a long-term change pattern of the battery.

According to an embodiment, the controller may be further configured to generate the time period-specific life change information of the battery for each repetition round of a same path when the vehicle is repeatedly driven on the same path, and the communication unit may be further configured to transmit the time period-specific life change information of the battery for each repetition round of the same path to the other device.

According to an embodiment, the controller may be further configured to, when extracting the life change information of the battery having a sharply declining life from the time period-specific life change information of the battery, extract battery data corresponding to a life sharp decline period, and the communication unit may be further configured to transmit the battery data corresponding to the life sharp decline period to the other device.

An operating method of a battery management apparatus according to an embodiment disclosed herein includes generating life (state of health (SoH)) change information of a battery based on battery data, generating time period-specific life change information of the battery based on the life change information of the battery, and predicting a time period-specific end of life (EoL) of the battery based on the time period-specific life change information of the battery.

According to an embodiment, the operating method may further include transmitting the time period-specific life change information of the battery and the time period-specific end of life of the battery to another device of a vehicle having the battery mounted thereon.

According to an embodiment, the generating of the time period-specific life change information of the battery based on the life change information of the battery may include generating at least any one of a short-term life change pattern, a mid-term life change pattern, and a long-term life change pattern of the battery based on the life change information of the battery.

According to an embodiment, the generating of the time period-specific life change information of the battery based on the life change information of the battery may include generating the time period-specific life change information of the battery by calculating a simple average value of the life change information of the battery for each time period or inputting the life change information of the battery into any one of a moving average filter (MAF) or a recursive weighted filter.

According to an embodiment, the predicting of the time period-specific end of life of the battery based on the time period-specific life change information of the battery may include obtaining driving information of a vehicle having the battery mounted thereon and predicting the time period-specific end of life of the battery based on a latest driving history of the vehicle and the time period-specific life change information of the battery.

According to an embodiment, the predicting of the time period-specific end of life of the battery based on the time period-specific life change information of the battery may include predicting the time period-specific end of life of the battery, which corresponds to at least any one of a short-term change pattern, a mid-term change pattern, and a long-term change pattern of the battery.

### [ADVANTAGEOUS EFFECTS]

With a battery management apparatus and an operating method thereof according to an embodiment disclosed herein, a SoH deterioration rate of a battery may be analyzed for each time period to provide expected end-of-life information of the battery for multiple time periods reflecting the latest driving history of a vehicle.

### [DESCRIPTION OF DRAWINGS]

FIG. 1 illustrates a battery pack according to an embodiment disclosed herein.
FIG. 2 is a block diagram illustrating a configuration of a battery management apparatus, according to an embodiment disclosed herein.
FIG. 3 is a graph showing a SoH change of a battery over time, according to an embodiment disclosed herein.
FIG. 4 is a flowchart of an operating method of a battery management apparatus according to an embodiment disclosed herein.
FIG. 5 is a block diagram showing a hardware configuration of a computing system for implementing a battery management apparatus according to an embodiment disclosed herein.

### [MODE FOR INVENTION]

Hereinafter, some embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present document.

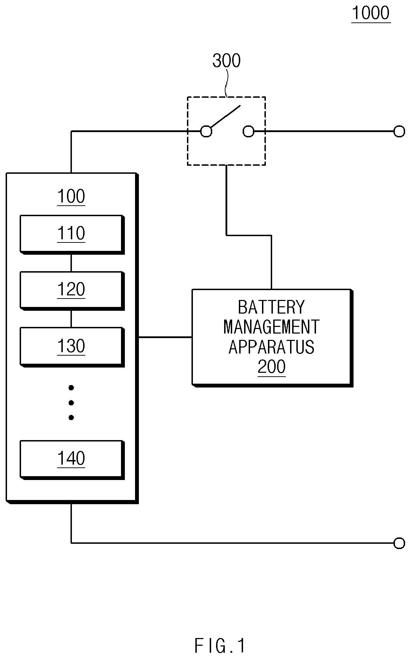

FIG. 1 illustrates a battery pack according to an embodiment disclosed herein.

Referring to FIG. 1, a battery pack 1000 according to an embodiment disclosed herein may include a battery module 100, a battery management apparatus 200, and a relay 300.

The battery module 100 may include a plurality of battery cells 110, 120, 130, and 140. Although the plurality of battery cells are illustrated as four in FIG. 1, the present disclosure is not limited thereto, and the battery module 100 may include n battery cells (n is a natural number equal to or greater than 2).

The battery module 100 may supply power to a target device (not shown). To this end, the battery module 100 may be electrically connected to the target device. Herein, the target device may include an electrical, electronic, or mechanical device that operates by receiving power from the battery pack 1000 including the plurality of battery cells 110, 120, 130, and 140, and the target device may be, for example, an electric vehicle (EV) or an energy storage system (ESS) but is not limited thereto.

The plurality of battery cells 110, 120, 130, and 140, each of which is a basic unit of a battery available by charging and discharging electrical energy, may be a lithium ion (Li-ion) battery, an Li-ion polymer battery, a nickel-cadmium (Ni-Cd) battery, a nickel hydrogen (Ni-MH) battery, etc., and are not limited thereto. Meanwhile, although one battery module 100 is illustrated in FIG. 1, the battery module 100 may be configured in plural according to an embodiment.

The battery management apparatus (a battery management system (BMS)) 200 may predict a life (a state of health (SoH)) of the plurality of battery cells 110, 120, 130, and 140 based on temperature and voltage data of the plurality of battery cells 110, 120, 130, and 140. The battery management apparatus 200 may remove noise from battery data of the plurality of battery cells 110, 120, 130, and 140 and predict a life (SoH) of the plurality of battery cells 110, 120, 130, and 140 for each of temperature and charge/discharge rate of a battery based on the noise-removed data.

The battery management apparatus 200 may manage and/or control a state and/or an operation of the battery module 100. For example, the battery management apparatus 200 may manage and/or control the states and/or operations of the plurality of battery cells 110, 120, 130, and 140 included in the battery module 100. The battery management apparatus 200 may manage charging and/or discharging of the battery module 100.

In addition, the battery management apparatus 200 may monitor a voltage, a current, a temperature, etc., of the battery module 100 and/or each of the plurality of battery cells 110, 120, 130, and 140 included in the battery module 100. A sensor or various measurement modules for monitoring performed by the battery management system, which are not shown, may be additionally installed in the battery module 100, a charging/discharging path, any position of the battery module 100, etc. The battery management apparatus 200 may calculate a parameter indicating a state of the battery module 100, e.g., a state of charge (SoC), a SoH, etc., based on a measurement value such as monitored voltage, current, temperature, etc.

The battery management apparatus 200 may control an operation of the relay 300. For example, the battery management apparatus 200 may short-circuit the relay 300 to supply power to the target device. The battery management apparatus 200 may short-circuit the relay 300 when a charging device is connected to the battery pack 1000.

The battery management apparatus 200 may calculate a cell balancing time of each of the plurality of battery cells 110, 120, 130, and 140. Herein, the cell balancing time may be defined as a time required for balancing of the battery cell. For example, the battery management apparatus 200 may calculate a cell balancing time based on an SoC, a battery capacity, and a balancing efficiency of each of the plurality of battery cells 110, 120, 130, and 140.

For the plurality of battery cells 110, 120, 130, and 140, as a period of use or the number of times of use increases, a capacity may decrease, internal resistance may increase, and various factors of the battery may change. The battery management apparatus 200 may calculate the life of the battery based on data of various factors changing with deterioration of the battery. More specifically, the battery management apparatus 200 may calculate the SoH of the plurality of battery cells 110, 120, 130, and 140 based on data of various factors changing with deterioration of the plurality of battery cells 110, 120, 130, and 140. The SoH is an index indicating a health state or life state of the battery in the current state with respect to an initial state of the battery. A moment at which the SoH reaches 0 % may be defined as an end of life (EoL). In addition, the end of life of the battery may be a moment at which the capacity of the battery reaches a guaranteed capacity or less.

For example, the battery management apparatus 200 may calculate the SoH of the plurality of battery cells 110, 120, 130, and 140 based on at least any one factor of internal resistance, impedance, conductance, capacity, voltage, self-discharge current, charge performance, and the number of times of charge and discharge of the plurality of battery cells 110, 120, 130, and 140, which change with deterioration of the plurality of battery cells 110, 120, 130, and 140.

Hereinbelow, a configuration and an operation of the battery management apparatus 200 will be described in detail.

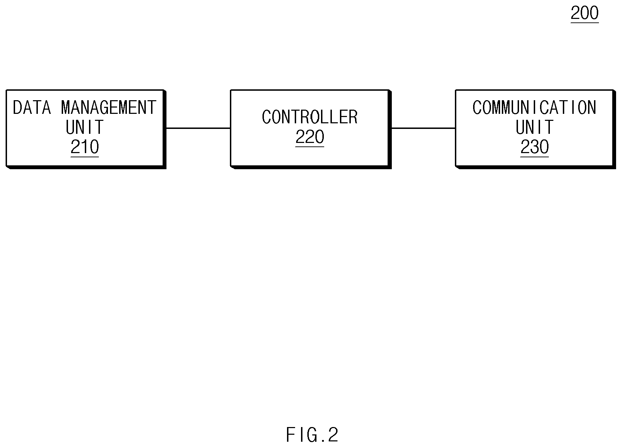

FIG. 2 is a block diagram showing a configuration of a battery life prediction apparatus, according to an embodiment disclosed herein.

First, referring to FIG. 2, the battery management apparatus 200 may include a data management unit 210, a controller 220, and a communication unit 230.

The data management unit 210 may obtain battery data of the plurality of battery cells 110, 120, 130, and 140 including at least any one of voltage, current, temperature of the plurality of battery cells 110, 120, 130, and 140 or state information of a battery pack having the battery mounted thereon.

The data management unit 210 may generate life change information of the plurality of battery cells 110, 120, 130, and 140 over time based on the battery data of the plurality of battery cells 110, 120, 130, and 140. More specifically, the data management unit 210 may generate SoH change information of the plurality of battery cells 110, 120, 130, and 140 over time based on the battery data of the plurality of battery cells 110, 120, 130, and 140.

The data management unit 210 may process the life change information of the plurality of battery cells 110, 120, 130, and 140 for each time period to generate time period-specific life change information of the plurality of battery cells 110, 120, 130, and 140.

For example, the data management unit 210 may calculate a simple average value of the life change information of the plurality of battery cells 110, 120, 130, and 140 for each of multiple time periods to generate the time period-specific life change information of the plurality of battery cells 110, 120, 130, and 140. First, the data management unit 210 may remove an outlier to remove measurement error data or system noise data included in the life change information of the plurality of battery cells 110, 120, 130, and 140.

For example, the data management unit 210 may input the life change information of the plurality of battery cells 110, 120, 130, and 140 into a moving average filter (MAF) to generate the time period-specific life change information of the plurality of battery cells 110, 120, 130, and 140. Herein, the moving average filter may be a scheme for sequentially filtering data by obtaining an average of an adjacent data in consecutive data. The moving average filter may calculate an average while moving in a data collection range, thereby alleviating an error caused by a rapid change in consecutive data.

Moreover, for example, the data management unit 210 may input the life change information of the plurality of battery cells 110, 120, 130, and 140 into a recursive weighted filter to generate the time period-specific life change information of the plurality of battery cells 110, 120, 130, and 140.

According to an embodiment, the data management unit 210 may process the life change information of the plurality of battery cells 110, 120, 130, and 140 for each time period over time to generate at least any one of a short-term life change pattern, a mid-term life change pattern, and a long-term life change pattern of the plurality of battery cells 110, 120, 130, and 140. Herein, a short term may mean one day, a mid-term may mean one week, and a long term may mean one month.

According to an embodiment, the data management unit 210 may process the life change information of the plurality of battery cells 110, 120, 130, and 140 for each time period over time to generate at least any one of a short-term SoH deterioration rate, a mid-term SoH deterioration rate, and a long-term SoH deterioration rate of the plurality of battery cells 110, 120, 130, and 140.

Moreover, the controller 220 may predict a time period-specific EoL of the plurality of battery cells 110, 120, 130, and 140 by processing the time period-specific life change information of the plurality of battery cells 110, 120, 130, and 140. More specifically, the controller 220 may predict the time period-specific EoL of the plurality of battery cells 110, 120, 130, and 140 based on an initial SoH value of the plurality of battery cells 110, 120, 130, and 140 and the time period-specific life change pattern of the plurality of battery cells 110, 120, 130, and 140.

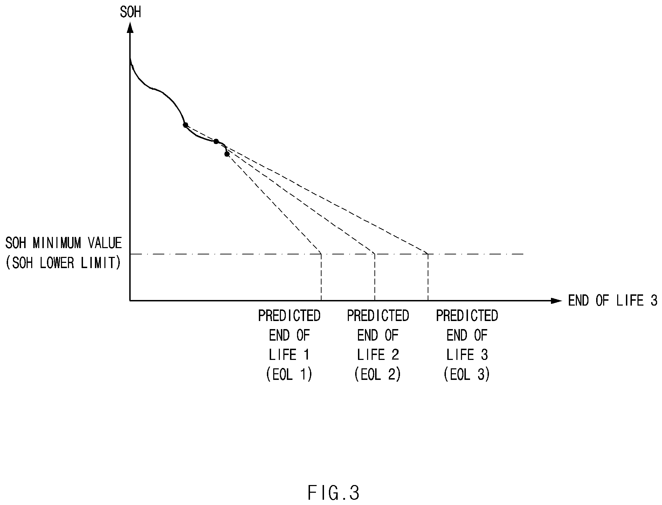

FIG. 3 is a graph showing a SoH change of a battery over time, according to an embodiment disclosed herein.

Referring to FIG. 3, the controller 220 may set the initial SoH value of the plurality of battery cells 110, 120, 130, and 140 to a start value and show a SoH deterioration rate of the plurality of battery cells 110, 120, 130, and 140 over time. More specifically, the controller 220 may extract a time period-specific SoH deterioration graph of the plurality of battery cells 110, 120, 130, and 140 having the initial SoH value of the plurality of battery cells 110, 120, 130, and 140 as Y-intercept value, based on the life change data of the plurality of battery cells 110, 120, 130, and 140 measured up to an observation timepoint. The controller 220 may predict, as a time period-specific EoL of the plurality of battery cells 110, 120, 130, and 140, a timepoint at which a Y-axis value of the time period-specific SoH deterioration graph of the plurality of battery cells 110, 120, 130, and 140 reaches a SoH minimum value (SoH lower limit).

According to an embodiment, the controller 220 may obtain driving information of a vehicle from another device (not shown) of the vehicle having the battery pack 1000 mounted thereon. Herein, the driving information of the vehicle may be defined as a motion input while a user of the vehicle uses the vehicle or an electronic device installed on the vehicle and characteristics of the motion. For example, the driving information of the vehicle may include use information of the battery pack 1000 according to user's vehicle driving.

The controller 220 may predict a time period-specific end of life of the plurality of battery cells 110, 120, 130, and 140 based on the latest driving history information of the vehicle and the time period-specific life change information of the plurality of battery cells 110, 120, 130, and 140. That is, the controller 220 may extract the time period-specific life change pattern of the plurality of battery cells 110, 120, 130, and 140 mounted on the vehicle based on the latest driving history information of the obtained driving information of the vehicle to reflect the latest driving pattern of the vehicle.

The controller 220 may extract the driving pattern of the vehicle by applying the driving information of the vehicle to machine learning. According to an embodiment, the controller 220 may generate the time period-specific life change information of the plurality of battery cells 110, 120, 130, and 140 for each repetition round of the same path when the vehicle is repeatedly driven on the same path. The controller 220 may compare the time period-specific life change information of the plurality of battery cells 110, 120, 130, and 140 for each repetition round of the same path.

The controller 220 may extract life change information of the plurality of battery cells 110, 120, 130, and 140 corresponding to a period in which the life of the plurality of battery cells 110, 120, 130, and 140 is sharply reduced, out of the time period-specific life change information of the plurality of battery cells 110, 120, 130, and 140.

The communication unit 230 may receive information about driving of the vehicle from another device of the vehicle. Herein, another device of the vehicle may be an electronic control unit (ECU) of the vehicle according to an embodiment. The electronic control unit of the vehicle may communicate with another electronic control unit of the vehicle without a host computer in the vehicle through CAN communication.

The communication unit 230 may transmit at least any one of the time period-specific life change information of the plurality of battery cells 110, 120, 130, and 140 and the time period-specific end of life of the plurality of battery cells 110, 120, 130, and 140.

The communication unit 230 may transmit the time period-specific life change information, generated by the controller 220, of the plurality of battery cells 110, 120, 130, and 140 for each repetition round of the same path.

When the communication unit 230 extracts the life change information of the plurality of battery cells 110, 120, 130, and 140 in which the life of the plurality of battery cells 110, 120, 130, and 140 sharply declines, out of the time period-specific life change information of the plurality of battery cells 110, 120, 130, and 140, the communication unit 230 may transmit battery data of the plurality of battery cells 110, 120, 130, and 140 corresponding to a life sharp decline period to another device. More specifically, the communication unit 230 may transmit vehicle driving information of a round where a SoH deterioration rate of the plurality of battery cells 110, 120, 130, and 140 sharply declines or a change value of the plurality of battery cells 110, 120, 130, and 140 to another device of the vehicle.

As described above, the battery management apparatus 200 according to an embodiment disclosed herein may analyze a SoH deterioration rate of a battery for each time period to provide expected end-of-life information of the battery for multiple time periods reflecting the latest driving history of a vehicle.

The battery management apparatus 200 may express an expected life the battery of the vehicle finally has with an EoL rather than a SoH, thereby improving the intuitive feature of battery management.

The battery management apparatus 200 may generate a SoH deterioration graph of the battery reflecting the latest driving history of the vehicle in advance analyzing driving information of the vehicle having the battery mounted thereon, and provide the same to the user of the vehicle. Thus, the battery management apparatus 200 may compare and provide expected end-of-life data corresponding to the vehicle driving history to the user of the vehicle to improve driving habit and driving pattern of the user of the vehicle and thus extend the use life of the battery.

That is, the battery management apparatus 200 may induce active participation of the user of the vehicle in optimization of the life of the battery by providing the expected end of life of the battery for each time period, thereby maximizing the performance of the battery. Moreover, by providing information about the deterioration trend of the battery from time to time, the user may easily accept a process of reaching the final end of life of the battery.

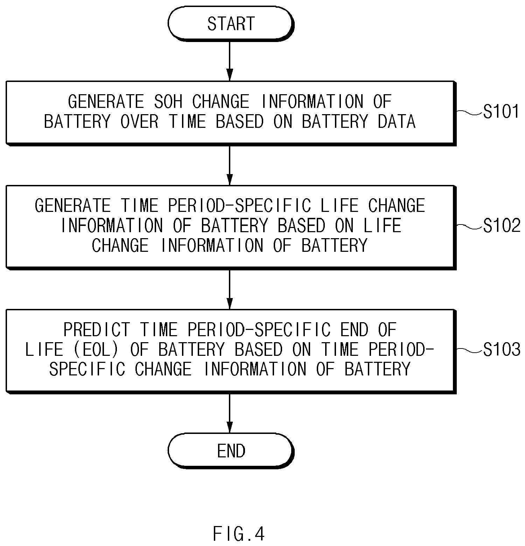

FIG. 4 is a view showing an operating method of a battery management apparatus according to an embodiment disclosed herein.

Referring to FIG. 4, an operating method of a battery management apparatus may include operation S 101 of generating life (SoH) change information of a battery over time based on battery data, operation S102 of generating time period-specific life change information of the battery by processing the life change information of the battery, and operation S103 of predicting the time period-specific EoL of the battery based on the time period-specific life change information of the battery.

In operation S101, the data management unit 200 may obtain battery data of the plurality of battery cells 110, 120, 130, and 140 including at least any one of voltage, current, temperature of the plurality of battery cells 110, 120, 130, and 140 or state information of a battery pack having the battery mounted thereon.

In operation S101, the data management unit 210 may generate life change information of the plurality of battery cells 110, 120, 130, and 140 over time based on the battery data of the plurality of battery cells 110, 120, 130, and 140. More specifically, the data management unit 210 may generate SoH change information of the plurality of battery cells 110, 120, 130, and 140 over time based on the battery data of the plurality of battery cells 110, 120, 130, and 140.

In operation S102, the data management unit 210 may process the life change information of the plurality of battery cells 110, 120, 130, and 140 for each time period to generate time period-specific life change information of the plurality of battery cells 110, 120, 130, and 140.

In operation S102, for example, the data management unit 210 may calculate a simple average value of the life change information of the plurality of battery cells 110, 120, 130, and 140 for each specific time period to generate the time period-specific life change information of the plurality of battery cells 110, 120, 130, and 140. First, the data management unit 210 may remove an outlier to remove measurement error data or system noise data included in the life change information of the plurality of battery cells 110, 120, 130, and 140.

In operation S102, for example, the data management unit 210 may input the life change information of the plurality of battery cells 110, 120, 130, and 140 into an MAF to generate the time period-specific life change information of the plurality of battery cells 110, 120, 130, and 140. Herein, the moving average filter may be a scheme for sequentially filtering data by obtaining an average of an adjacent data in consecutive data. The moving average filter may calculate an average while moving in a data collection range, thereby alleviating an error caused by a rapid change in consecutive data.

In operation S102, for example, the data management unit 210 may input the life change information of the plurality of battery cells 110, 120, 130, and 140 into a recursive weighted filter to generate the time period-specific life change information of the plurality of battery cells 110, 120, 130, and 140.

In operation S102, the data management unit 210 may process the life change information of the plurality of battery cells 110, 120, 130, and 140 for each time period over time to generate at least any one of a short-term life change pattern, a mid-term life change pattern, and a long-term life change pattern of the plurality of battery cells 110, 120, 130, and 140. Herein, a short term may mean one day, a mid-term may mean one week, and a long term may mean one month.

In operation S103, the controller 220 may predict a time period-specific EoL of the plurality of battery cells 110, 120, 130, and 140 by processing the time period-specific life change information of the plurality of battery cells 110, 120, 130, and 140. More specifically, in operation S103, the controller 220 may predict the time period-specific EoL of the plurality of battery cells 110, 120, 130, and 140 based on an initial SoH value of the plurality of battery cells 110, 120, 130, and 140 and the time period-specific life change pattern of the plurality of battery cells 110, 120, 130, and 140. In operation S103, for example, the controller 220 may predict, as a time period-specific EoL of the plurality of battery cells 110, 120, 130, and 140, a timepoint at which a Y-axis value of the time period-specific SoH deterioration graph of the plurality of battery cells 110, 120, 130, and 140 reaches a SoH minimum value.

In operation S103, the controller 220 may predict a time period-specific end of life of the plurality of battery cells 110, 120, 130, and 140 based on the latest driving history information of the vehicle and the time period-specific life change information of the plurality of battery cells 110, 120, 130, and 140. In operation S103, that is, the controller 220 may extract the time period-specific life change pattern of the plurality of battery cells 110, 120, 130, and 140 mounted on the vehicle based on the latest driving history information of the obtained driving information of the vehicle to reflect the latest driving pattern of the vehicle.

In operation S103, the controller 220 may extract the driving pattern of the vehicle by applying the driving information of the vehicle to machine learning. According to an embodiment, the controller 220 may generate the time period-specific life change information of the plurality of battery cells 110, 120, 130, and 140 for each repetition round of the same path when the vehicle is repeatedly driven on the same path. In operation S103, the controller 220 may compare the time period-specific life change information of the plurality of battery cells 110, 120, 130, and 140 for each repetition round of the same path.

In operation S103, the controller 220 may extract life change information of the plurality of battery cells 110, 120, 130, and 140 corresponding to a period in which the life of the plurality of battery cells 110, 120, 130, and 140 is sharply reduced, out of the time period-specific life change information of the plurality of battery cells 110, 120, 130, and 140.

In operation S103, the communication unit 230 may transmit at least any one of the time period-specific life change information of the plurality of battery cells 110, 120, 130, and 140 and the time period-specific end of life of the plurality of battery cells 110, 120, 130, and 140.

In operation S103, the communication unit 230 may transmit the generated time period-specific life change information of the plurality of battery cells 110, 120, 130, and 140 for each repetition round of the same path.

In operation S103, when the communication unit 230 extracts the life change information of the plurality of battery cells 110, 120, 130, and 140 in which the life of the plurality of battery cells 110, 120, 130, and 140 sharply declines, out of the time period-specific life change information of the plurality of battery cells 110, 120, 130, and 140, the communication unit 230 may transmit battery data of the plurality of battery cells 110, 120, 130, and 140 corresponding to a life sharp decline period to another device.

In operation S103, more specifically, the communication unit 230 may transmit vehicle driving information of a round where a SoH deterioration rate of the plurality of battery cells 110, 120, 130, and 140 sharply declines or a change value of the plurality of battery cells 110, 120, 130, and 140 to another device of the vehicle.

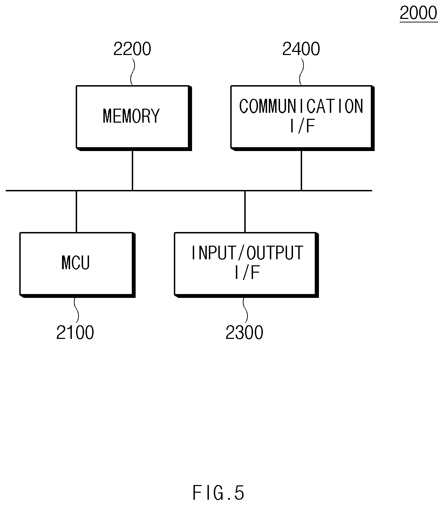

FIG. 5 is a block diagram showing a hardware configuration of a computing system for implementing a battery management apparatus according to an embodiment disclosed herein.

Referring to FIG. 5, a computing system 2000 according to an embodiment disclosed herein may include an MCU 2100, a memory 2200, an input/output I/F 2300, and a communication I/F 2400.

The MCU 2100 may be a processor that executes various programs (e.g., a battery life end time prediction program, etc.) stored in the memory 2200, processes various data through these programs, and perform the above-described functions of the battery management apparatus 200 shown in FIG. 1.

The memory 2200 may store various programs regarding operations of the battery management apparatus 200. Moreover, the memory 2200 may store operation data of the battery management apparatus 200.

The memory 2200 may be provided in plural, depending on a need. The memory 2200 may be volatile memory or non-volatile memory. For the memory 2200 as the volatile memory, random access memory (RAM), dynamic RAM (DRAM), static RAM (SRAM), etc., may be used. For the memory 2200 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 2200 are merely examples and are not limited thereto.

The input/output I/F 2300 may provide an interface for transmitting and receiving data by connecting an input device (not shown) such as a keyboard, a mouse, a touch panel, etc., and an output device such as a display (not shown), etc., to the MCU 2100.

The communication I/F 2400, which is a component capable of transmitting and receiving various data to and from a server, may be various devices capable of supporting wired or wireless communication. For example, a program for resistance measurement and abnormality diagnosis of the battery cell or various data may be transmitted and received to and from a separately provided external server through the communication I/F 2400.

The above description is merely illustrative of the technical idea of the present disclosure, and various modifications and variations will be possible without departing from the essential characteristics of the present disclosure by those of ordinary skill in the art to which the present disclosure pertains.

Therefore, the embodiments disclosed in the present disclosure are intended for description rather than limitation of the technical spirit of the present disclosure and the scope of the technical spirit of the present disclosure is not limited by these embodiments. The protection scope of the present disclosure should be interpreted by the following claims, and all technical spirits within the same range should be understood to be included in the range of the present disclosure.

## Claims

1. A battery management apparatus comprising:
a data management unit configured to generate time period-specific life change information of a battery based on life (state of health (SoH)) change information of the battery; and
a controller configured to predict a time period-specific end of life (EoL) of the battery based on the time period-specific life change information of the battery.

2. The battery management apparatus of claim 1, further comprising a communication unit configured to transmit the time period-specific life change information of the battery and the time period-specific end of life of the battery to another device of a vehicle having the battery mounted thereon.

3. The battery management apparatus of claim 1, wherein the data management unit is further configured to generate life change information of the battery over time based on at least any one of voltage, current, temperature of the battery or state information of a battery pack having the battery mounted thereon.

4. The battery management apparatus of claim 3, wherein the data management unit is further configured to generate at least any one of a short-term life change pattern, a mid-term life change pattern, and a long-term life change pattern of the battery based on the life change information of the battery over time.

5. The battery management apparatus of claim 3, wherein the data management unit is further configured to generate the time period-specific life change information of the battery by calculating a simple average value of the life change information of the battery for each time period or inputting the life change information of the battery into any one of a moving average filter (MAF) or a recursive weighted filter.

6. The battery management apparatus of claim 4, wherein the controller is further configured to obtain driving information of a vehicle having the battery mounted thereon and predict the time period-specific end of life of the battery based on a latest driving history of the vehicle and the time period-specific life change information of the battery.

7. The battery management apparatus of claim 6, wherein the controller is further configured to predict the time period-specific end of life of the battery, which corresponds to at least any one of a short-term change pattern, a mid-term change pattern, and a long-term change pattern of the battery.

8. The battery management apparatus of claim 6, wherein the controller is further configured to generate the time period-specific life change information of the battery for each repetition round of a same path when the vehicle is repeatedly driven on the same path, and
the communication unit is further configured to transmit the time period-specific life change information of the battery for each repetition round of the same path to the other device.

9. The battery management apparatus of claim 6, wherein the controller is further configured to, when extracting the life change information of the battery having a sharply declining life from the time period-specific life change information of the battery, extract battery data corresponding to a life sharp decline period, and
the communication unit is further configured to transmit the battery data corresponding to the life sharp decline period to the other device.

10. An operating method of a battery management apparatus, the operating method:
generating life (state of health (SoH)) change information of a battery based on battery data;
generating time period-specific life change information of the battery based on the life change information of the battery; and
predicting a time period-specific end of life (EoL) of the battery based on the time period-specific life change information of the battery.

11. The operating method of claim 10, further comprising transmitting the time period-specific life change information of the battery and the time period-specific end of life of the battery to another device of a vehicle having the battery mounted thereon.

12. The operating method of claim 10, wherein the generating of the time period-specific life change information of the battery based on the life change information of the battery comprises generating at least any one of a short-term life change pattern, a mid-term life change pattern, and a long-term life change pattern of the battery based on the life change information of the battery.

13. The operating method of claim 12, wherein the generating of the time period-specific life change information of the battery based on the life change information of the battery comprises generating the time period-specific life change information of the battery by calculating a simple average value of the life change information of the battery for each time period or inputting the life change information of the battery into any one of a moving average filter (MAF) or a recursive weighted filter.

14. The operating method of claim 10, wherein the predicting of the time period-specific end of life of the battery based on the time period-specific life change information of the battery comprises obtaining driving information of a vehicle having the battery mounted thereon and predicting the time period-specific end of life of the battery based on a latest driving history of the vehicle and the time period-specific life change information of the battery.

15. The operating method of claim 14, wherein the predicting of the time period-specific end of life of the battery based on the time period-specific life change information of the battery comprises predicting the time period-specific end of life of the battery, which corresponds to at least any one of a short-term change pattern, a mid-term change pattern, and a long-term change pattern of the battery.
